# EUROPÄISCHE PATENTSCHRIFT

(11) **EP 0 579 955 B1**
(45) Veröffentlichungstag und Bekanntmachung des Hinweises auf die Patenterteilung: **06.12.2000**
(21) Anmeldenummer: 93109667.1
(22) Anmeldetag: 17.06.1993
(51) Int. Cl.: H04H 1/00, H03J 1/00

(54) **Abstimmung eines Empfängers in Abhängigkeit der Sprache des Senders**
Tuning of a receiver according to the language of transmitter
Accord d'un récepteur en fonction de la langue de l'émetteur

(30) Priorität: 22.06.1992 DE 4219994
(43) Veröffentlichungstag der Anmeldung: 26.01.1994
(73) Patentinhaber: Thomson Consumer Electronics Sales GmbH, 30453 Hannover (DE)
(72) Erfinder: Göken, Klaus, D-3100 Celle-Boye (DE)

(56) Entgegenhaltungen:
- EP-A- 0 263 253
- EP-A- 0 429 000
- DE-A- 3 832 454

## Beschreibung

Die Erfindung betrifft ein Verfahren zur Empfängerabstimmung gemäß dem Oberbegriff des Anspruchs 1. Ein solches Verfahren ist bekannt aus der Spezifikation des Radio-Daten-Systems (RDS), welches der europäischen Norm 50067 (DIN 50067) entspricht. Dabei werden RDS-Datensignale auf einem Unterträger übertragen, der am Eingang des VHS-FM-Senders dem Multiplexsignal einem Stereo- oder Mono-signals zugesetzt wird. Während einer Stereosendung wird der Unterträger mit der dritten Harmonischen des 19 kHz Pilottons gekoppelt, so daß während einer Sendung die Unterträgerfrequenz etwa 57 kHz beträgt. Ferner ist aus der DE 39 38 457 A1 ein RDS-Rundfunkempfänger bekannt, bei dem eine länderspezifische Auswertung bzw. Anzeige der im RDS-Datentsignal enthaltenen Informationen mittels einer mit dem PI-Code empfangenen Länderkennung erfolgt.

Empfangsseitig wird in einem entsprechenden für das RDS-System ausgelegten Rundfunkempfänger das RDS-Datensignal demoduliert, decodiert und die RDS-Daten einer Steuereinheit zur Auswertung zugeführt. Durch einen in einem Speicher abgelegten Betriebsprogramm läßt sich der Empfänger entsprechend einer vorbestimmten Zweckbestimmung bedienen und wird auf das gewünschte oder vorbestimmte Programm abgestimmt.

Der Erfindung liegt die Aufgabe zugrunde, eine vereinfachte, den individuellen Wünschen des Benutzers besser angepaßte Programmierung und Bedienung des vorstehend beschriebenen Empfängers zu ermöglichen.

Gemäß der vorliegenden Erfindung wird die Aufgabe durch die kennzeichnenden Merkmale des Anspruchs 1 gelöst. Der Anspruch 3 betrifft einen entsprechenden Empfänger.

Vorteilhafte Ausgestaltungen der Erfindung sind in den Unteransprüchen beschrieben.

Der Erfindung liegt die Erkenntnis zugrunde, daß die Übertragung einer codierte Information über die Sprache des Programms des Senders eine völlig neuartige, sehr vorteilhafte und für den Benutzers einfache Bedienung des Rundfunkgerätes erlaubt. Insbesondere dann, wenn der Benutzer den Empfang von Programmen in einer ihm gewünschten Sprache verlangt, kann mittels der Erfindung eine einfache Einstellung eines oder nacheinander mehrerer Programme, die in der gewünschten Sprache senden, vorgenommen werden.

Es ist zwar aus der RDS-Spezifikation bekannte, in der Programm-Identifikation (PI)-Struktur, der sogenannten Programm-kettenkennung, eine codierte Information über die Länderkennung des Senders zu übertragen, diese Länderkennung kann jedoch regelmäßig nicht dazu verwendet werden, daß der Empfänger nur Programme in einer vorbestimmten Sprache empfängt, weil im Bereich politischer Grenzen, die keine Sprachgrenze darstellen, die Länderkennung unterschiedlich ist. Aber auch innerhalb eines politischen Gebietes wie z.B. der Bundesrepublik, werden Rundfunkprogramme wie z.B. "Radio France", "BBC" usw. ausgestrahlt, die nicht in der Amtssprache dem Benutzer einen Hörgenuß verleihen. Da durch die grenzübergreifenden Kulturen auch immer mehr sprachübergreifende Rundfunkprogramme innerhalb eines Landes ausgestrahlt werden, ist es wünschenswert, daß der Benutzer seinen Empfänger automatisch auf Programme mit der von ihm gewünschte Sprache einstellen kann.

Mittels der Erfindung wird darüberhinaus eine bessere Übersicht über die empfangbaren Programme in einem vorgegebenen Frequenzband erreicht, da bei Voreinstellung auf eine gewünschte Sprache alle Programme bzw. Sender, die nicht in der gewünschten Programmsprache übertragen, erst gar nicht dem Benutzer angeboten werden.

Es sind verschiedene Möglichkeiten denkbar die Programmsprachenkennung - nachfolgend auch Language Number (LN) genannt - im Kennsignal-Datenstrom unterzubringen. So läßt sich beispielsweise die Language Number in einen Radiotextsegment des RDS-Datenstroms Gruppentyp Nr. 2, in eine rundfunkinterne Information des RDS-Signals bei Gruppentyp Nr. 6, in einem transparenten Datenkanal des RDS-Signals bei Gruppentyp Nr. 5, oder an einer anderen Stelle des RDS-Signals unterbringen. Ebenso ist denkbar, daß für den erfindungsgemäßen Vorschlag eine neue bisher nicht vergebene Gruppentyp Nr. bereitgestellt wird. Somit offenbart die Erfindung einen zum bisherigen RDS-System vollkompatiblen Vorschlag, der die Bedienung und den schnelleren Zugriff auf ein gewünschtes Programm ermöglicht, wobei bisherige RDS-Rundfunkempfänger in keiner Weise in ihrer Funktion beeinträchtigt werden.

Nachfolgend wird die Erfindung anhand von Ausführungsbeispielen in der Zeichnung näher erläutert. In der Zeichnung stellen dar
- Fig. 1: ein Blockschaltbild eines erfindungsgemäßen RDS-Rundfunkempfängers,
- Fig. 2: ein Flußdiagramm für den Steuerungsablauf beim Wechsel auf eine andere Empfangsfrequenz

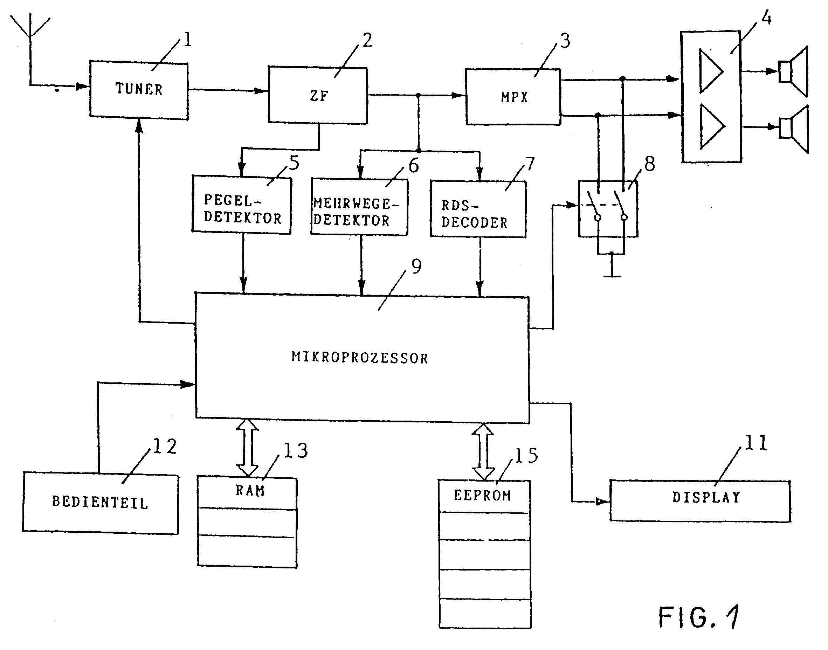

Der in Fig. 1 dargestellte RDS-Rundfunkempfänger enthält einen Tuner 1, einen ZF-Verstärker 2 zum selektiven Verstärken und Demodulieren der Zwischenfrequenz, einen Stereo-Decoder 3 zum Decodieren des Stereo-Multiplexsignals und eine Stereo-Enstufe 4. Als zentrale Steuereinheit, verbunden mit dem Bedienteil 12, dient ein Mikroprozessor 9, der auch zur Sendereinstellung das notwendige Abstimmsignal an den Tuner liefert. Die Epfangsqualität wird mit dem Pegeldetektor 5 und dem Mehrwegedetektor 6 überwacht.

Der Pegeldetektor 5 entnimmt dem ZF-Verstärker 2 nach Maßgabe des ZF-Signalpegels eine Meßgröße zur Feststellung der Signalfeldstärke bzw. Signalqualität, während der Mehrwegedetektor 6 hochfrequente Störamplituden im Multiplexsignal, verursacht durch Mehrwegeempfang, auswertet. Die Analog/Digital-Wandlung der Steuersignale für den Mikroprozessor 9 erfolgt entweder in den beiden Detektoren 5, 6 oder im Mikroprozessor 9, sofern er mit entsprechenden Wandlereingängen versehen ist.

Der RDS-Decoder 7 wird ebenfalls mit dem demodulierten Multiplexsignal gespeist. Nach einer 57 kHz Bandpaßfilterung wird das in Quadraturamplituden modulierte RDS-Signal demoduliert und die nach einer anschließenden Biphase- und differential gewonnen digitalen Daten zur Weiterverarbeitung dem Mikroprozessor 9 zugeführt.

Als Arbeitspeicher und Zusatzspeicher besitzt der Mikroprozessor 9 den ROM-Speicher 13 mit mehreren Speicherebenen. Im ROM-Speicher 13 sind ein oder mehrere verschiedene Betriebsprogramme abgelegt. Der EEPROM-Speicher 15 dient als nichtflüchtiger Programmspeicher und beinhaltet in seinen einzelnen Speicherebenen für jedes abgespeicherte Programm neben dem PI-Code und PS-Code (program service name-code für die Anzeige des Namens einer Programmkette) eine Anzahl ausgewählter alternativer Frequenzen für einen spontanen Programmaufruf.

Die in der jeweiligen Speicherebene des Programmspeichers 15 enthaltenen Daten werden bei Abruf eines bestimmten Programms durch den Mikroprozessor 9 in den Arbeitsspeicher - erste Speicherebene des ROM-Speichers 13 - übertragen. Anschließend werden die AF's durch kurzzeitiges Abstimmen des Empfängers im Bezug auf Feldstärke, Mehrwegeempfang, Sendermittel, RDS-Übertragungsqualität und PI-Code überprüft und entsprechend ihrer Empfangsqualität in der Reihenfolge sortiert. Schließlich wird der Tuner 1 durch den Mikroprozessor 9 auf die Frequenz mit der besten Signalqualität abgestimmt.

Neben den alternativen Frequenzen eines Programms und weiteren Daten z.B. die zur Anzeige des Sendernamens dienen, werden im RDS-Signal eine dem Programm zugeordnete Information übertragen, die der Sprache z.B. "Deutsch" des Programms zugeordnet ist. Diese Information LN wird wie die alternativen Frequenzen im EEPROM-Speicher 15 abgelegt.

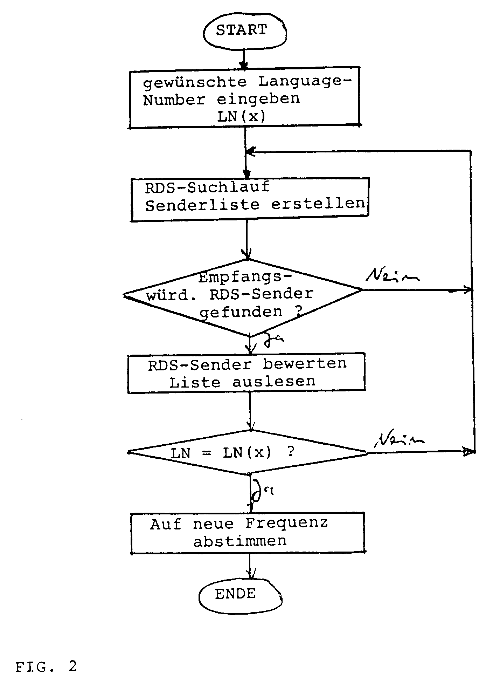

Durch das Bedienteil 12 oder automatisch kann ein Sendersuchlauf ausgelöst werden, bei dem über die Empfangswürdigkeit eines Senders neben dem Qualitätskriterien auch oder alternativ wie die im RDS-Signal übertragene Information über die Sprache des Programms entscheidend ist. Wird beispielsweise ein Sendersuchlauf nach Programmen, die hauptsächlich die gesprochene Sprache "deutsch" verwenden, durchgeführt, so werden vom Mikroprozessor nur diejenigen Programme als empfangswürdig eingestuft, die die codierte Information LN gleich entsprechend "deutsch" in ihrem RDS-Signal enthalten. Jeder Sprache eines bestimmten Gebietes z.B. Europa wird sendeseitig eine individuelle LN zugeordnet. Bei einem Sendersuchlauf wird wie in Fig. 2 dargelegt, die Einstufung der Empfangswürdigkeit neben anderen Parametern auch davon abhängig gemacht, ob ein empfangbarer Sender auch die gewünschte LN mitsendet. Somit wird bei der Listenerstellung der empfangbaren Sender nur Frequenzen der Sender gespeichert, die auch in der gewünschten Sprache ihr Programm, d.h. insbesondere die Sprache der Wortbeiträge, aussenden. Nach Beendigung des Suchlaufs können vom Benutzer alle empfangbaren Sender eingestellt werden, die in der von ihm gewünschten Sprache ihre Wortbeiträge übertragen.

So kann z.B. ein englischsprachiger Benutzer mittels der Erfindung innerhalb von Deutschland ohne Kenntnis der Frequenzen, auf denen englischsprachige Programme übertragen werden, sehr schnell die Frequenzen der Sender feststellen und abrufbereit speichern, die ihre Wortbeiträge durchgehend in englischer Sprache ausstrahlen. Da innerhalb von Deutschland die Zahl der englischsprachigen Sender zwischen Zwei und Fünf schwankt, die Zahl der deutschsprachigen Sender jedoch ein mehrfaches davon beträgt, wird in diesem Anwendungsfall dem Benutzer eine große Übersichtlichkeit über die empfangbaren Sender geboten.

Die Erfindung ist nicht auf einen RDS-Rundfunkempfänger beschränkt. Sie ist ebenso auf Fernsehempfänger wie auch auf andere Systeme wie digitale Speichermedien, Aufzeichnungs- oder Wiedergabegeräte für die Medien usw. anwendbar. So ist es beispielsweise auch denkbar, daß bei einer Wortbeitrags- oder Musikaufnahme in einem Zusatzdatenkanal eine codierte Information über die Sprache der Wortbeitrags- oder Musikaufnahme auf dem Aufzeichnungsträger - in diesem Fall Sender - gespeichert und als Kriterium zur bestimmungsgemäßen Umschaltung eines Aufzeichnungs- oder Wiedergabegerätes - in diesem Fall Empfangsgerät - verwendet wird.

## Patentansprüche

1. Verfahren zur Empfängerabstimmung, bei dem die Träger- oder Hilfsträgerfrequenz oder der Zusatzdatenkanal wenigstens eines Senders zeitweise oder dauernd mit einem Kennsignal moduliert oder versehen wird, welches durch Demodulation und/oder Decodierung im Empfänger wiedergewonnen wird und in Abhängigkeit von Bedienungseingaben zur Einstellung des Empfängers benutzbar ist, wobei der Sender ein sendeeigenes Kenndatum an den Empfänger überträgt, **dadurch gekennzeichnet**, daß das Kenndatum (LN) eines Senders eine codierte Information über die Programmsprache des Senders enthält, und daß die codierte Information zur Abstimmung des Empfängers auf einen Sender, der im wesentlichen in der gewünschten Programmsprache aussendet, verwendet wird.

2. Verfahren nach Anspruch 1, **dadurch gekennzeichnet**, daß die codierte Information durch ein Radio-Daten-System (RDS) übertragen wird.

3. Empfänger für ein Verfahren nach Anspruch 1 oder 2 mit einem Decoder (7), einem Speicher (13, 15) und einer Steuereinheit (9), **dadurch gekennzeichnet**, daß der Decoder (7) derart ausgestaltet ist, daß er zur Wiedergewinnung eines Kennsignals, welches in Abhängigkeit von Bedienungseingaben zur Einstellung des Empfängers benutzbar ist, geeignet ist und der Steuereinheit eine im Kennsignal enthaltene codierte Information über die Programmsprache des Senders liefert, wobei die Steuereinheit (9) die im Programmsignal enthaltene Programmsprachenkennung für eine Abstimmung des Empfängers verwendet.

4. Empfänger nach Anspruch 3, **dadurch gekennzeichnet**, daß der Empfänger ein Rundfunkempfänger, vorzugsweise ein RDS-Rundfunkempfänger ist, daß die Steuereinheit als Mikroprozessor (9) ausgebildet ist, der nach Aufrufen der im Speicher (15) abgelegten sprachspezifischen Variante des Betriebsprogramms den Wechsel auf alternative Frequenzen im Arbeitsspeicher (13) automatisch oder nach Bedienungsangabe (12) der für die jeweilige Programmsprache festgelegten Wechselstrategie vollzieht.

5. Empfänger nach Anspruch 3 oder 4 **dadurch gekennzeichnet**, daß der Empfänger ein Display (11) zur Anzeige der übertragenen Programmsprache des Senders enthält.

6. Empfänger nach einem der Ansprüche 3 - 5, **dadurch gekennzeichnet,** daß der Empfänger eine Einrichtung (5, 6) zur Beurteilung der Empfangsqualität aufweist, und bei Verschlechterung der Empfangsverhältnisse entsprechend die für die jeweilige Sprache festgelegte Wechselstrategie vollzieht.

7. Empfänger nach einem der Ansprüche 3-6, **dadurch gekennzeichnet**, daß die Steuereinheit die vom Decoder (7) gelieferten im Rundfunkkennsignal enthaltenen Programmsprachenkennungen auswertet und vorzugsweise nur RDS-Empfangsfrequenzen mit gleicher Programmsprachkennung (LN) in den Arbeitspeicher (13) übernimmt.

8. Empfänger nach einem der Ansprüche 3-7, **dadurch gekennzeichnet**, daß die Steuereinheit (9) über einen mechanischen oder elektronischen Schalter (12) zusätzlich derart programmierbar ist, daß bei einem automatischen Suchlauf nur Sender mit der vor Beginn des Suchlaufs empfangenen Programmsprachenkennung (LN) ausgewählt werden und daß die Frequenzen der beim Suchlauf gefundennen Sender gespeichert werden.

9. Empfänger nach einem der Ansprüch 3-8, **dadurch gekennzeichnet**, daß der Empfänger ein Aufzeichnungs- und/oder Wiedergabegerät ist und daß der Sender ein Aufzeichnungsträger ist.

## Claims

1. Method for tuning a receiver wherein the carrier or auxiliary carrier frequency or the additional data channel of at least one transmitter is temporarily or continuously modulated or provided with an identification signal which is recovered by demodulation and/or decoding in the receiver and, in dependence on the operating input conditions, is utilisable for the tuning of the receiver, wherein the transmitter transmits an item of identification data unique to the transmitter to the receiver, **characterised in that**, the identification data (LN) of a transmitter contains a coded item of information regarding the programme language of the transmitter and that the coded item of information is used for the tuning of the receiver to a transmitter which, in essence, emits in the desired programme language.

2. Method in accordance with claim 1, **characterised in that**, the coded item of information is transmitted via a Radio-Data-System (RDS).

3. Receiver for a method in accordance with claim 1 or 2 including a decoder (7), a memory (13, 15) and a control unit (9), **characterised in that**, the decoder (7) is designed in such a way that it is appropriate for recovering an identification signal which can be used for tuning the receiver in dependence from operating input conditions and provides a coded information concerning the programme language of the transmitter included within the identification signal for the control unit wherein the control unit (9) makes use of the programme language identification included within the programme signal for the tuning of the receiver.

4. Receiver in accordance with claim 3, **characterised in that**, the receiver is a radio broadcast receiver, preferably an RDS broadcast receiver, that the control unit is formed as a microprocessor (9) which, after calling up the language specific variant of the operating programme installed in the store (15), automatically or in accordance with the operating indication (12) of the change strategy laid down for the respective programme language, executes the change to alternative frequencies in the working store (3).

5. Receiver in accordance with claim 3 or 4, **characterised in that**, the receiver contains a display (11) for the indication of the transmitted programme language of the transmitter.

6. Receiver in accordance with any of claims 3 - 5, **characterised in that**, the receiver has a device (5, 6) for judging the quality of reception and, upon a deterioration of the reception conditions, correspondingly executes the change strategy laid down for the current language.

7. Receiver in accordance with any one of claims 3 - 6, **characterised in that**, the control unit evaluates the programme language identification contained in the radio broadcast identification signal delivered by the decoder and preferably only accepts RDS receiving frequencies having the same programme language identification (NL) into the working store (13).

8. Receiver in accordance with any one of claims 3 - 7, **characterised in that**, the control unit (9) is additionally programmable by a mechanical or electronic switch (12) in such a way that during an automatic self-seeking search mode only transmitters having the programme language identification (LN) received before the start of the self-seeking search are selected and that the frequencies of the transmitters found during the self-seeking search mode are stored.

9. Receiver in accordance with any one of claims 3 - 8, **characterised in that**, the receiver is a recording and/or reproducing device and that the transmitter is a record carrier.

## Revendications

1. Procédé d'accord d'un récepteur dans lequel la fréquence porteuse ou sous-porteuse ou le canal de donnée supplémentaire d'au moins un émetteur est modulé avec un signal d'identification ou fournit ce signal par intermittence ou en permanence, lequel est récupéré dans le récepteur lors de la démodulation et/ou du décodage et utilisable en fonction des indications d'utilisation pour l'accord du récepteur et dans lequel l'émetteur transmet au récepteur des données caractéristiques à l'émission, **caractérisé en ce que** les données caractéristiques (LN) d'un émetteur contiennent des informations codées sur la langue du programme de l'émetteur et en ce que les informations codées sont utilisées pour accorder le récepteur sur un émetteur dont les programmes sont essentiellement émis dans la langue souhaitée.

2. Procédé conforme à la revendication 1, **caractérisé en ce que** les informations codées sont transmises via un système de radiocommunication de données (RDS).

3. Récepteur destiné à un procédé conforme à la revendication 1 ou 2 et comportant un décodeur (7), une mémoire (13, 15) et une unité de commande (9), **caractérisé en ce que** le décodeur (7) est conçu de sorte qu'il permette la récupération d'un signal d'identification, utilisable en fonction des indications de réglage du récepteur et en ce que l'unité de commande fournit des informations codées sur la langue des programmes et contenues dans le signal d'identification, dans lequel l'unité de commande (9) utilise l'identification des langues des programmes contenue dans le signal du programme pour procéder à l'accord du récepteur.

4. Récepteur conforme à la revendication 3, **caractérisé en ce que** le récepteur est un récepteur de radiodiffusion, de préférence RDS, et en ce que l'unité de commande constitue un microprocesseur (9) qui, après l'appel de la variante du programme de fonctionnement propre à la langue mémorisée, procède au changement de fréquences alternatives dans la mémoire de travail (13), automatiquement ou après indication d'utilisation (12) de la stratégie de changement de fréquence définie pour chaque langue de programme.

5. Récepteur conforme à la revendication 3 ou 4, **caractérisé en ce que** le récepteur comporte un écran (11) permettant de visualiser la langue du programme de l'émetteur.

6. Récepteur conforme à l'une des revendications 3 à 5, **caractérisé en ce que** le récepteur présente un dispositif (5, 6) permettant d'évaluer la qualité de réception et exécutant la stratégie de changement de fréquence définie appropriée à chaque langue en cas de dégradation des conditions de réception.

7. Récepteur conforme à l'une des revendications 3 à 6, **caractérisé en ce que** l'unité de commande évalue les identifications des langues des programmes contenues dans le signal d'identification de la radio transmises par le décodeur (7) et, de préférence, ne prend en charge que les fréquences de réception RDS présentant une identification de langue des programmes (LN) identique dans la mémoire de travail (13).

8. Récepteur conforme à l'une des revendications 3 à 7, **caractérisé en ce que** l'unité de commande (9) est également programmable sur un commutateur mécanique au électronique (12) de sorte que, dans le cas d'une recherche automatique des stations, seuls les émetteurs possédant l'identification de langue des programmes (LN) avant le lancement de la recherche seront sélectionnés et que les fréquences des émetteurs trouvés lors de la recherche automatique seront mémorisées.

9. Récepteur conforme à l'une des revendications 3 à 8, **caractérisé en ce que** le récepteur est un appareil d'enregistrement et/ou de reproduction et l'émetteur un support d'enregistrement.
